Europäisches Patentamt

European Patent Office

Office européen des brevets

(11) Numéro de publication: **0 221 812 B1**

# (12) FASCICULE DE BREVET EUROPEEN

(45) Date de publication de fascicule du brevet: **26.08.92** (51) Int. Cl.⁵: **C23C 16/50**, H01J 37/32

(21) Numéro de dépôt: **86402312.2**

(22) Date de dépôt: **15.10.86**

(54) **Appareil et son procédé d'utilisation pour la formation de films minces assistée par plasma.**

(30) Priorité: **25.10.85 FR 8515910**

(43) Date de publication de la demande:
**13.05.87 Bulletin 87/20**

(45) Mention de la délivrance du brevet:
**26.08.92 Bulletin 92/35**

(84) Etats contractants désignés:
**BE CH DE GB IT LI LU NL SE**

(56) Documents cités:
**GB-A- 2 118 212**
**US-A- 4 328 258**

**IBM TECHNICAL DISCLOSURE BULLETIN, vol. 24, no. 12, mai 1982, pages 6268-6269, New York, US; L.M. EPHRATH: "Plasma reactor for dry development of resist"**

**PATENT ABSTRACTS OF JAPAN, vol. 9, no. 52 (C-269)[1775], 6 mars 1985, page 141 C 269; & JP-A-59 193 265 (STANLEY DENKI K.K.) 01-11-1984**

**PATENT ABSTRACTS OF JAPAN, vol. 7, no. 166 (E-188)[1311], 21 juillet 1983, page 52 E 188; & JP-A-58 73 111 (SUWA SEIKOSHA K.K.) 02-05-1983**

(73) Titulaire: **SOLEMS S.A. Société dite:**
**3, rue Léon Blum Z.I. Les Glaises**
**F-91120 Palaiseau(FR)**

(72) Inventeur: **Schmitt, Jacques**
**51, Grande Rue**
**F-91620 La Ville du Bois(FR)**

(74) Mandataire: **Lerner, François**
**5, rue Jules Lefèbvre**
**F-75009 Paris(FR)**

Rank Xerox (UK) Business Services

**Description**

La présente invention a pour objet un appareil et un procédé d'utilisation de celui-ci pour la formation de films minces au moyen d'un dépôt de vapeur chimique assisté par plasma.

Ce type d'appareil permet le dépôt d'une grande variété de matériaux sous forme de films minces par décomposition, dans une enceinte sous pression réduite, d'un ou de plusieurs gaz réactifs dilués ou non dans un ou plusieurs gaz porteurs. La décomposition est induite par décharge électrique dans le gaz.

La technique propose notamment un appareil comprenant une enceinte sous pression réduite non étanche aux gaz, renfermant au moins un gaz réactif, au moins une plaque support, appelée substrat, sur laquelle viendra se déposer le film mince après décomposition des gaz réactifs, et au moins une électrode en forme de plaque polarisée située en regard dudit substrat, l'enceinte en question étant disposée dans une chambre extérieure étanche aux gaz. Le substrat et l'enceinte sont généralement reliés à la masse. Cependant l'efficacité de ce type d'appareil, c'est-à-dire la quantité de matière suffisamment "pure" effectivement déposée sur le substrat par rapport à la quantité de matières utilisées, et son rendement énergétique, sont relativement faibles. On trouve notamment des exemples de tels appareils aux brevets US-A-4 328 258 et JP-A-5 873 111 ("Patents abstracts of Japan n° 52, Vol. 9"), aucun d'eux ne permettant de limiter, de par sa construction, les problèmes de contamination des matériaux déposés dûs notamment au "dégazage" des parois de l'enceinte ou de la chambre et des autres pièces qui y sont contenues.

Il convient donc que l'appareil de dépôt soit, dans son ensemble, conçu pour éviter ces contaminations et permettre une maintenance aisée, les électrodes et les autres parois de l'appareil se recouvrant assez rapidement d'une épaisseur croissante de dépôt qu'il convient d'éliminer régulièrement soit par une méthode de gravure par plasma (décapage), soit par l'intervention d'un opérateur. En effet, le film, formé par la décomposition des gaz réactifs se dépose, dans la plupart des appareils connus, non seulement sur le substrat, mais aussi dans l'ensemble de l'enceinte.

L'invention a pour objet de résoudre les difficultés sus-mentionnées.

A cet effet, conformément à l'invention, on va créer et maintenir dans la chambre extérieure étanche qui entoure l'enceinte, une pression inférieure à celle qui règne dans cette enceinte.

De préférence, on utilisera en tant qu'électrode une fine grille à larges mailles. Cette configuration se prête à une très bonne uniformité de dépôt et l'essentiel du matériau peut alors se déposer effectivement sur les substrats supports du film mince, et non pas sur d'autres parois de l'appareil ou sur l'electrode.

On aurait pu penser qu'une telle fine structure ajourée aurait été rapidement endommagée, du fait notamment de la puissance électrique élevée généralement appliquée, et aurait nui au bon fonctionnement de l'appareil. Or il n'en n'a rien été. Une électrode avec une telle configuration permet, au contraire, d'améliorer sensiblement le rendement de l'appareil, sans pour autant nuire à la transmission des ondes dans le milieu gazeux de réaction.

On va maintenant présenter l'invention plus en détail en faisant pour cela référence aux dessins annexés dans lesquels :
- la figure 1 montre, schématiquement et en coupe, l'enceinte qui comporte, notamment, les substrats et une électrodes,
- la figure 2 montre un schéma d'appareil présentant deux contre-électrodes, deux substrats et une électrode centrale,
- la figure 3 montre, schématiquement, un appareil présentant deux substrats et trois électrodes,
- la figure 4 montre, schématiquement, un appareil présentant deux substrats et deux électrodes,
- la figure 5 montre, schématiquement, un appareil présentant deux contre-électrodes, deux substrats et une électrode centrale,
- la figure 6 présente l'enceinte de la figure 1 située dans la chambre étanche.

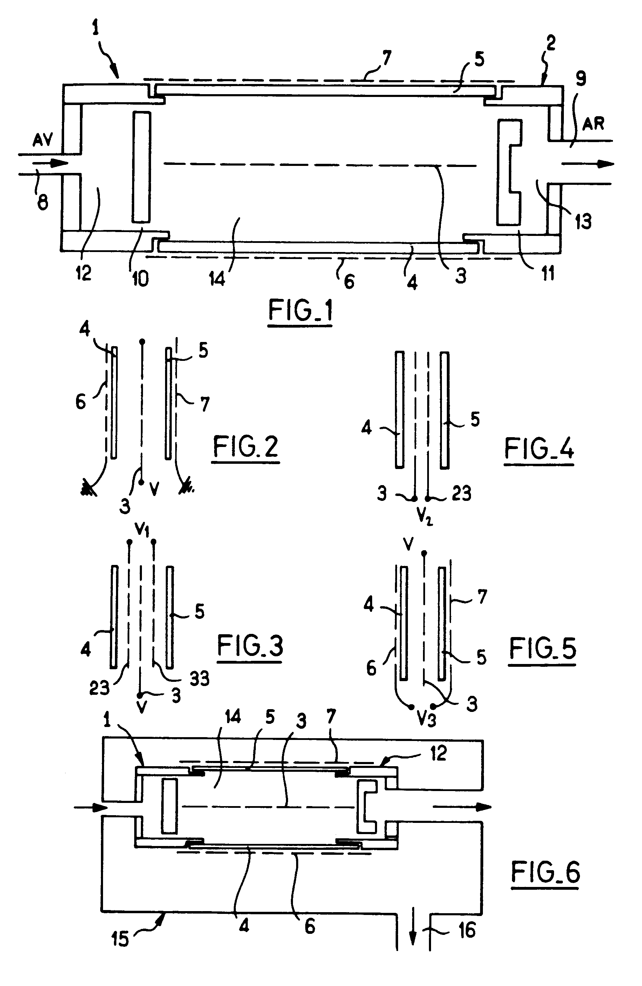

En se reportant, tout d'abord à la figure 1 l'appareil, repéré dans son ensemble 1, comporte une enceinte 2, dans laquelle arrivent, par un conduit 8 d'alimentation, les gaz réactifs débouchant avantageusement dans l'enceinte par une ouverture située à l'extrémité longitudinale avant 12 de l'enceinte.

L'enceinte 2, qui a la forme générale d'un parallèlépipède creux, se trouve obturée vers son extrémité longitudinale avant 12 par un premier étranglement 10 et vers son extrémité longitudinale arrière 13 par un second étranglement 11. Les gaz se trouvant dans l'enceinte 2 sont évacués à l'extrémité arrière 13 par le conduit 9. Sur la figure on a repéré par les lettres AV et AR le côté respectivement "avant" et "arrière" de l'enceinte en faisant référence à la circulation des gaz dans l'appareil tel que schématisé par les flèches.

Dans l'exemple illustré, deux plaques supports du film 4 et 5, les substrats, sont logées dans les parois latérales de l'enceinte 2 et disposées sensiblement parallèlement l'une à l'autre. Les substrats 4 et 5 comportent chacun sur leur face arrière, c'est-à-dire sur la face sur laquelle ne se déposera pas le film généré par les gaz réactifs, une contre-électrode 6, 7. Pour permettre que l'essentiel du matériau se dépose effectivement sur les substrats 4 et 5, l'enceinte 2 comporte un espace 14 ménagé entre lesdits substrats dans lequel est disposée, de façon sensiblement centrale, une électrode 3. Cette électrode 3 se présente sous la forme générale d'une plaque sensiblement plane à structure ajourée, c'est-à-dire dans laquelle sont ménagés des passages de circulation du milieu gazeux de réaction. Une électrode en forme de grille serait tout à fait adaptée.

Les contre-électrodes 6 et 7 pourraient également se présenter sous forme de grille.

En se référant à la figure 6, on voit que l'enceinte 2 est disposée dans une chambre étanche 15 dont le volume est supérieur à celui de l'enceinte 2 et dans laquelle règne une pression inférieure à celle de ladite enceinte. Le gaz sous pression réduite de la chambre 15 est évacué par le conduit 16 dans le sens indiqué par la flèche.

Conformément à la figure 2, qui est une représentation schématique du principe retenu à la figure 1, les substrats sont à la masse par l'intermédiaire des contre-électrodes 6, 7, et l'électrode centrale 3 reçoit la puissance électrique génératrice du plasma. La tension V appliquée peut être continue, alternative, voire alternative pulsée. La distance entre les substrats peut varier selon les utilisations mais le système ne garde son intérêt majeur que lorsque l'espacement entre les substrats reste inférieur ou de l'ordre des dimensions longitudinales et transversales de l'appareil. En outre, plus la "transparence" ou la porosité au milieu de réaction, de l'électrode est grande, c'est-à-dire plus les espaces ménagés dans sa structure sont importants, plus le rendement relatif au dépôt de matière augmente. Il est à noter que cette transparence de l'électrode peut cependans varier selon le dépôt recherché et l'environnement retenu. Les cas extrêmes vont de la plaque pleine (laquelle n'est généralement pas utilisée conformément à l'invention) jusqu'à quelques fils tendus en forme de grille,ou grillage, sur un cadre léger.

Si la décharge génératrice de plasma est alimentée par un générateur continu ou éventuellement alternatif, soit les substrats 4 et 5 doivent être conducteurs et assurer la fonction de deuxième électrode, soit,si les substrats sont isolants ou si l'on souhaite éviter le bombardement du substrat par des particules accélérées, on utilise avantageusement trois électrodes 3, 23 et 33 en forme de grille.

L'électrode centrale 3 est alors polarisée par rapport aux deux autres 23 et 33, entre lesquelles est établie une tension $V_1$, tel qu'illustré figure 3.

Dans le cas où la polarisation est réalisée en radio-fréquence, tension alternative, on peut utiliser deux électrodes désignées 3 et 23, entre lesquelles on établira une tension $V_2$, tel qu'illustré figure 4.

Il est à noter que dans les différents cas où la décharge est alimentée en tension alternative, l'autre électrode peut être assurée par les substrats 4 et 5 ou s'ils sont isolants par des plaques ou grilles, les contre-électrodes 6 et 7, placées directement sur la face arrière des substrats.

Les différents types de fonctionnement préconisés ci-dessus tendent à limiter l'importance du bombardement ionique, lequel, dans beaucoup de cas est défavorable, mais il existe des matériaux (carbone amorphe pour l'optique, couche d'accrochage, etc) pour lesquels un bombardement ionique est souhaitable. Dans un tel cas il suffit, selon l'invention, d'utiliser des plaques électrodes ayant une surface développée plus grande, telle qu'une structure alvéolaire.

Dans le cas où les substrats et les dépôts de films sont conducteurs, on peut pour obtenir un tel bombardement, les polariser par rapport à la ou les autres électrodes. Sinon, on peut brancher antisymétriquement les deux contre-électrodes (figure 5) disposées derrière les substrats aux bornes d'une source radio-fréquence de puissance. On génère donc une tension $V_3$ et l'on alimente alors, notamment par un générateur alternatif, la décharge génératrice de plasma sur la (les) électrodes.

Selon l'invention, on peut déposer une grande variété de matériaux sous forme de film mince par décomposition dans une enceinte sous pression réduite, d'un ou de plusieurs gaz réactifs dilués ou non dans un ou plusieurs gaz porteurs. Les semi-conducteurs déposés peuvent être dopés par adjonction, dans le mélange de gaz, d'un transporteur de l'élément dopant. Les propriétés du matériau dépendent en général fortement de la pureté chimique du milieu réactant et du bombardement ionique (flux, énergie) auquel est soumis le film pendant sa croissance.

Voici quelques exemples de matériaux et de gaz générateurs :

| Semi-conducteurs | Gaz |
|---|---|
| silicium amorphe hydrogéné | $SiH_4$, $Si_2H6$ |
| As Ga | $Ga (CH_3)_3$, $AsH_3$ |
| Alliages divers | $CH_4$, $SiH_4$, $GeH_4$, $Sif_4$ |
| **Isolants** | |
| Silice | $SiH_4$, $O_2$, $N_2O$ |
| Nitrure de silicium | $SiH_4$, $N_2$, $NH_3$ |
| Polymères | Gaz monomères |
| **Conducteurs** | |
| Métaux | Organométalliques |

En se référant aux figures 1 et 6, on note que les gaz réactifs sont injectés dans l'enceinte 2 et rencontrent le premier étranglement 10, appelé aussi répartiteur, qui permet une distribution homogène des gaz dans l'enceinte. Après séjour en présence du plasma de déposition, les gaz qui sont évacués par le conduit 9 passent dans le deuxième étranglement 11 pour ajuster leur pression. L'évacuation des gaz est généralement réalisée par pompage.

On notera en outre que la chambre 15 à pression très réduite dans laquelle est logée l'enceinte 2 limite considérablement les problèmes de contamination du matériau déposé sur les substrats par des impuretés "parasitaires".

Les fuites de gaz de l'enceinte vers la chambre étanche ainsi que le dégazage de la chambre, des parois extérieures de l'enceinte, des systèmes de chauffage et autres mécanismes présents dans la chambre, sont évacués généralement par une pompe à vide, qui est dimensionnée pour maintenir la pression résiduelle dans la chambre à un niveau très inférieur à celui de l'enceinte.

La figure 6 présente une chambre étanche adaptée à la géométrie de l'enceinte.

Diverses variantes peuvent être apportées au mode de réalisation illustré et décrit.

C'est ainsi que l'on peut prévoir une ou plusieurs électrodes se présentant sous forme de plaques perforées planes dont on adapte les dimensions des orifices de passage en fonction du rendement et du dépôt recherché.

Par ailleurs, on notera que dans le mode de fonctionnement de la figure 2, on n'a représenté qu'une seule électrode (3). Cependant, on peut prévoir plusieurs électrodes, tel que montré figure 3 ou figure 4. On peut, notamment, en se référant à la figure 4, prévoir deux électrodes (3, 23) de polarité opposée, soumises à une décharge électrique génératrice de plasma et disposées entre deux substrats (4, 5) reliés à la masse.

**Revendications**

1. Procédé pour la formation de films minces au moyen d'un dépôt de vapeur chimique assisté par plasma effectué au sein d'un appareil comprenant une enceinte (2) non étanche aux gaz renfermant au moins un gaz réactif, au moins un substrat (4, 5) en forme de plaque propre à supporter le film mince et au moins une électrode (3,13,23,33) polarisée en forme de plaque, génératrice de plasma, ladite enceinte étant disposée à l'intérieur d'une chambre (15) étanche aux gaz, caractérisé en ce que l'on crée et on maintient dans la chambre étanche (15) une pression inférieure à celle qui règne dans l'enceinte (2) où circule ledit gaz réactif.

2. Procédé selon la revendication 1 caractérisé en ce qu'on utilise en tant qu'électrode une grille fine à larges mailles.

3. Procédé selon la revendication 1 ou la revendication 2 caractérisé en ce qu'on utilise deux substrats (4, 5) et trois électrodes (3, 23, 33) que l'on dispose parallèlement entre les deux substrats, l'électrode centrale (3) étant polarisée par rapport aux deux autres entre lesquelles on crée une différence de potentiel (figure 3).

**4.** Procédé selon la revendication 1 ou la revendication 2 caractérisé en ce que :
- on utilise deux électrodes (3, 23) et deux substrats (4, 5),
- on dispose les deux électrodes parallèlement entre les deux substrats que l'on relie à la masse,
- et on crée entre les électrodes une différence de potentiel.

**5.** Procédé selon la revendication 1 ou la revendication 2 caractérisé en ce que :
- on utilise une électrode (3) et deux substrats (4, 5) que l'on dispose parallèlement de part et d'autre de ladite électrode,
- on équipe chacun de ces substrats d'une contre-électrode (6, 7) que l'on dispose sur une face du substrat opposée à celle en regard de l'électrode,
- on relie les deux contre-électrodes à une source radio-fréquence de puissance de façon à créer entre ces deux contre-électrodes une différence de potentiel (V3),
- et on alimente l'électrode en énergie électrique à partir d'un générateur de courant alternatif (figure 5).

**6.** Procédé selon l'une quelconque des revendications précédentes caractérisé en ce qu'on rétrécie localement (en 10, 11) la section de passage du gaz réactif du côté des extrémités longitudinales avant (12) et arrière (13) de l'enceinte (2) par où ce même gaz est respectivement admis dans et évacué de ladite enceinte.

**Claims**

**1.** Process for forming thin films by means of plasma-assisted chemical vapour deposition performed inside an apparatus comprising a container (2) which is not impervious to gases and contains at least one reactive gas, at least one substrate (4, 5) in the form of a plate which can support the thin film and at least one polarised electrode (3, 13, 23, 33) which is in the form of a plate and generates plasma, the said container being disposed inside a chamber (15) which is impervious to gases, characterised in that a pressure which is less than that prevailing in the container (2) wherein the said reactive gas circulates is created in and maintained inside the impervious chamber (15).

**2.** Process according to Claim 1, characterised in that a fine large-meshed grid is used as the electrode.

**3.** Process according to claim 1 or 2, characterised in that there are used two substrates (4, 5) and three electrodes (3, 23, 33) which are disposed in a parallel manner between the two substrates, the central electrode (3) being polarised relative to the two other electrodes between which a potential difference is created (Figure 3).

**4.** Process according to Claim 1 or 2, characterised in that:
- two electrodes (3, 23) and two substrates (4, 5) are used;
- the two electrodes are disposed in a parallel manner between the two substrates which are earthed; and
- a potential difference is created between the electrodes.

**5.** Process according to Claim 1 or 2, characterised in that:
- there are used one electrode (3) and two substrates (4, 5) which are disposed in a parallel manner on either side of the said electrode;
- each of these substrates is provided with a counter-electrode (6, 7) which is disposed on one face of the substrate opposite the face facing the electrode;
- the two counter-electrodes are connected to a radio-frequency power source so as to create a potential difference (V3) between these two counter-electrodes; and
- the electrode is supplied with electrical energy from an alternating current generator (Figure 5).

**6.** Process according to any one of the preceding claims, characterised in that the passage cross-section of the reactive gas is contracted locally (at 10, 11) on the side of the front (12) and rear (13) longitudinal ends of the container (2) via which this gas is admitted to and evacuated from the said container respectively.

**Patentansprüche**

1. Verfahren für die Herstellung dünner Schichten mittels eines Niederschlages von chemischem Dampf durch Plasma, durchgeführt in einer Vorrichtung mit einem abgeschlossenen, für Gase nicht dichten Raum (2), der mindestens ein reagierendes Gas einschließt, mit mindestens einem Substrat (4, 5) in Plattenform zur Halterung der dünnen Schicht und mit mindestens einer polarisierten Elektrode (3, 13, 23, 33) in Plattenform, die Plasmaerzeugende, wobei der umschlossene Raum im Inneren einer gasdichten Kammer (15) angeordnet ist, dadurch gekennzeichnet, daß man in der dichten Kammer (15) einen Druck erzeugt und aufrecterhält, der niedriger ist als derjenige, der in dem geschlossenen Raum (2) herrscht, wo das reagierende Gas zirkuliert.

2. Verfahren nach Anspruch 1, dadurch gekennzeichnet, daß man als Elektrode ein feines Gitter mit weiten Maschen verwendet.

3. Verfahren nach Anspruch 1 oder Anspruch 2, dadurch gekennzeichnet, daß man zwei Substrate (4, 5) und drei Elektroden (3, 23, 33) verwendet, die man zwischen den zwei Substraten parallel anordnet, wobei die mittlere Elektrode (3) bezüglich der zwei anderen polarisiert ist, zwischen welchen man eine Potentialdifferenz erzeugt (Figur 3).

4. Verfahren nach Anspruch 1 oder Anspruch 2, dadurch gekennzeichnet, daß:
   - man zwei Elektroden (3, 23) und zwei Substrate (4, 5) verwendet,
   - man die zwei Elektroden parallel zwischen den zwei Substraten anordnet, die man mit der Masse verbindet,
   - und daß man zwischen den Elektroden eine Potentialdifferenz erzeugt.

5. Verfahren nach Anspruch 1 oder Anspruch 2, dadurch gekennzeichnet, daß:
   - man eine Elektrode (3) und zwei Substrate (4, 5) verwendet, die man parallel auf beiden Seiten der Elektrode anordnet,
   - man jedes dieser Substrate mit einer Gegenelektrode (6, 7) ausstattet, die man auf einer Fläche des Substrates anordnet, welche der bezüglich der Elektrode gegenüber angeordnet ist,
   - man die zwei Gegenelektroden mit einer Radiofrequenzleistungsquelle derart verbindet, daß zwischen diesen zwei Gegenelektroden eine Potentialdifferenz (V3) erzeugt wird,
   - und daß man die Elektrode mit elektrischer Energie speist, die von einem Wechselstromgenerator stammt (Figur 5).

6. Verfahren nach einem der vorhergehenden Ansprüche, dadurch gekennzeichnet, daß man örtlich (bei 10, 11) den Durchgangsquerschnitt für das reagierende Gas an den Längsenden vor (12) und hinter (13) dem umschlossenen Raum (2) reduziert, wo dasselbe Gas in den umschlossenen Raum hineingeführt bzw. aus diesem abgezogen wird.

FIG.1

FIG.2

FIG.4

FIG.3

FIG.5

FIG.6